# EUROPEAN PATENT APPLICATION

(11) **EP 2 412 520 A1**
(43) Date of publication of application: **01.02.2012**
(21) Application number: 10755861.1
(22) Date of filing: 10.03.2010
(51) Int. Cl.: B32B 15/20, B32B 15/01, C23C 28/02, C25D 7/06, H05K 1/09

(54) **METAL FOIL WITH ELECTRIC RESISTANCE FILM AND PRODUCTION METHOD THEREFOR**

(30) Priority: 25.03.2009 JP 2009073052
(71) Applicant: JX Nippon Mining & Metals Corporation, Tokyo 100-8164 (JP)
(72) Inventor: KUROSAWA Toshio, Hitachi-city Ibaraki 317-0056 (JP)
(74) Representative: Hoarton, Lloyd Douglas Charles
(86) International application number: PCT/JP2010/053953
(87) International publication number: WO 2010/110061

(57) **Abstract**

A metal foil comprising an electric resistance film in which the metal foil is made of copper or copper alloy, the surface roughness of at least one surface thereof is set to a 10-point average roughness Rz of 6.0 µm to 8.0 µm, and an electric resistance film is formed on that surface, wherein the peel strength of the electric resistance film is 0.60 kN/m or more, and variation of the resistance value is +10% or less. Provided is a copper foil with an electric resistance film in which an electric resistance film is formed on the copper foil to enable the resistor to be built into the substrate, the adhesiveness thereof to a resin substrate is ensured, and variation of the resistivity of the electric resistance film is reduced.

## Description

### TECHNICAL FIELD

The present invention relates to a metal foil made of copper or copper alloy with an electric resistance film having high peel strength and low variation of the electric resistance value, and to a method of producing the same.
In the foregoing case, since the electric resistance film is of a layered structure with the copper foil, it can also be deemed an "electric resistance layer," but in this specification, this is referred to as an "electric resistance film" inclusive of the foregoing meaning.
Moreover, a metal foil made of copper or copper alloy can generally be classified as an electrolytic copper foil or a rolled copper foil, but in the present invention these are collectively referred to as a "copper foil." In addition, although these can also be classified as a copper foil or a copper alloy foil, these are also collectively referred to as a "copper foil." As described above, unless specifically identified and referred to, these are indicated as a "copper foil" herein.

### BACKGROUND ART

A copper foil is generally used as the wiring material of a printed circuit board. A copper foil is classified into an electrolytic copper foil and a rolled copper foil based on the production method thereof. The thickness of the copper foil can be arbitrarily adjusted from an extremely thin copper foil with a thickness of 5 µm to a thick copper foil with a thickness of approximately 140 µm.

These copper foils are bonded to a substrate made of resin such as epoxy or polyimide, and are used as a printed circuit board. Since a copper foil is required to possess sufficient adhesive strength for adhering to the resin as the substrate, with an electrolytic copper foil, its coarse surface referred to as the matte surface which is generally formed during the production thereof is used by being additionally subject to surface roughening treatment. With a rolled copper foil, its surface is also subject to roughening treatment prior to use.

In recent years, proposals have been made for additionally forming a thin film made of an electric resistance material on the copper foil as the wiring material (refer to Patent Documents 1 and 2). An electric resistive element is essential in an electronic circuit board, and, if a copper foil comprising a resistive layer is used, it is only necessary to expose the resistive element of the electric resistance film formed on the copper foil using an etching solution such as copper chloride.
Accordingly, as a result of building the resistor into the substrate, the limited surface area of the substrate can be effectively used in comparison to conventional methods of having to mount a chip resistive element on the surface of the substrate with solder bonding.

Moreover, design restrictions can be reduced by forming a resistive element in a multi-layered substrate, and the electrical properties can be improved since the circuit length can be shortened. Accordingly, if a copper foil comprising a resistive layer is used, solder bonding becomes unneeded or is considerably alleviated, and weight-saving can be achieved and reliability can be improved. As described above, a substrate with a built-in electric resistance film yields numerous advantages.

Meanwhile, when forming the electric resistance film on the surface of the copper foil, it is necessary to take measures so that it will not peel easily. In many cases, the surface roughness of the copper foil is increased based on surface treatment in order to achieve peel strength. Nevertheless, if the surface roughness is increased in order to achieve the foregoing peel strength, there is a problem in that the resistance value will vary considerably.
Conventionally, measurement of the surface roughness of the copper foil has been performed with the stylus method prescribed in JISB0601, but with this method, it is not possible to discover the correlation of the surface roughness of the copper foil and the fluctuation or variation of the electric resistance value of the resistance film.

Accordingly, upon forming an electric resistance film on the copper foil, only the adhesive strength was emphasized, and until now the fluctuation or variation of the electric resistance caused by the roughness of the roughened surface of the copper foil has been ignored. Nevertheless, if the resistance value of the resistance layer formed on the copper foil is subject to fluctuation or variation, this is not a favorable state since it will cause deterioration in the quality upon forming the resistance layer on a substrate with an electric resistance film built therein. A conventional copper foil comprising an electric resistance film encounters the foregoing problems, and a copper foil with an electric resistance film capable of achieving both the sufficient adhesive strength upon bonding to the resin substrate and the reduction in the variation of the resistance value as an electric resistance film has not yet been realized.

[Patent Document 1] Japanese Patent No. 3311338
[Patent Document 2] Japanese Patent No. 3452557

### SUMMARY OF THE INVENTION

The present invention provides a metal foil with an electric resistance film in which an electric resistance film is formed on the copper foil to enable the resistor to be built into the substrate, the adhesiveness thereof to a resin substrate is ensured, and variation of the electric resistance value of the electric resistance film is reduced, as well as a method of producing the same.

As a result of intense study to achieve the foregoing object, the present inventors discovered that it is effective to use a surface roughness based on a specific optical measurement method and adjust such surface roughness in order to yield a certain level of adhesiveness between the copper foil and the electric resistance film, and to reduce the variation of the resistivity.

Based on the foregoing discovery, the present invention provides.
1) A metal foil with an electric resistance film in which the metal foil is made of copper or copper alloy, the surface roughness of at least one surface thereof is set to a 10-point average roughness Rz of 6.0 µm to 8.0 µm, and an electric resistance film is formed on that surface, wherein the peel strength of the electric resistance film is 0.60 kN/m or more, and variation of the resistance value is ± 10% or less.

The present invention additionally provides.
2) The metal foil with an electric resistance film according to paragraph 1) above, wherein the electric resistance layer is provided to the surface of an electrolytic copper foil or a rolled copper foil that was subject to roughening treatment.

The present invention further provides:
3) The metal foil with an electric resistance film according to paragraph 1) or paragraph 2) above, wherein the variation of the resistance value of the electric resistance film is ± 5 % or less.

The present invention additionally provides:
4) The metal foil with an electric resistance film according to any one of paragraphs 1) to 3) above, wherein the foil thickness of the metal foil is 5 to 35 µm.
   A copper foil having a foil thickness of 5 to 70 µm, particularly a copper foil of 5 to 35 µm can be used. The thickness of the copper foil can be selected arbitrarily according to the usage, but it would be efficient to produce the copper foil within the foregoing range due to the restrictions based on the manufacturing conditions.

The present invention further provides:
5) A method of producing a metal foil with an electric resistance film, wherein the surface of a copper or copper alloy metal foil made of an electrolytic copper foil or a rolled copper foil is subject to roughening treatment via electrolysis so that the surface roughness becomes a 10-paint average roughness of Rz 6.0 µm to 8.0 µm, and an electric resistance film is formed on the roughened surface via a physical surface treatment method such as a sputtering method, a vacuum deposition method, or an ion beam plating method, a chemical surface treatment method such as a pyrolysis method or a gas phase reaction methos, or a wet surface treatment method such an electroplating method or an electroless plating method, whereby the peel strength of the electric resistance film is 0.60 kN/m or more, and variation of the resistance value of the electric resistance film is ±5% or less.

The present invention additionally provides:
6) The method of producing a metal foil with an electric resistance film according to paragraph 5) above, wherein the variation of the resistance value of the electric resistance film is ±3% or less.

The present invention further provides:
7) The method of producing a metal foil with an electric resistance film according to paragraph 5) or paragraph 6) above, wherein coat plating is additionally performed after the roughening treatment via electrolysis.

The electric resistance film is arbitrarily decided according to the circuit design. Specifically, the type and film thickness of the electric resistance material are decided in consideration of the function of the resistive element, and there is no particular limitation.
As examples of materials used as the electric resistive element; for instance, there are materials such as vanadium, tungsten, zirconium, molybdenum, tantalum, nickel, and chromium. So as long as it is a metal with relatively high electric resistance, these metals can be respectively used as an independent film, or as an alloy film with other elements.

Moreover, even materials with a relatively low electric resistance such as aluminium, silicon, copper, iron, indium, zinc and tin can be alloyed with other elements and used if the resulting material has high electric resistance.
For example, electric resistive elements such as NiCr alloy and NiCrAlSi alloy are materials that are attracting attention. Moreover, oxides, nitrides and silicides selected from the oxides, nitrides and silicides of the foregoing elements can be used. As described above, the selection of these materials is made arbitrarily according to the circuit design, and it should be understood that there is no limitation to the foregoing materials.

Upon forming this electric resistance film, physical surface treatment methods such as the sputtering method, the vacuum deposition method and the ion beam plating method,; chemical surface treatment methods such as the pyrolysis method and the gas-phase reaction method; or a wet-type surface treatment method such as electroplating and electroless plating can be used.
Generally speaking, electroplating is advantageous in that the production can be performed with low cost. Moreover, the sputtering method is advantageous in that a high-quality resistive element can be obtained since the film has a uniform thickness and comprises isotropy.
The formation of the electric resistance film is made according to the usage of the film, and the adhesion method and plating method in such a case are desirably selected suitable according to the nature of the electric resistance film.

### [Effect of the Invention]

The present invention yields superior effects of being able to obtain a copper foil comprising an electric resistance film possessing favorable adhesiveness and capable of inhibiting the fluctuation or variation of the resistance value, which are drawbacks associated with a copper foil with an electric resistance film built therein.

### BRIEF DESCRIPTION OF THE DRAWING

Fig. 1 is a diagram showing an outline of the electrolytic copper foil production device.
Fig. 2 is a diagram showing the correlativity of the surface roughness measured with an optical roughness tester of the WYKO optical profiler, and the resistance value.
Fig. 3 is a diagram showing the correlativity of the surface roughness measured with a stylus roughness tester of the JIS standard, and the resistance value.

### BEST MODE FOR CARRYING OUT THE INVENTION

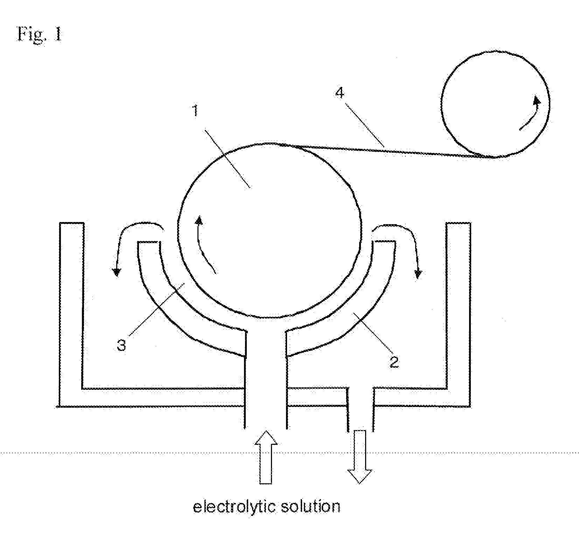

The outline of the manufacturing device of the electrolytic copper foil is shown in Fig. 1. With this device, a cathode drum is placed in an electrolytic bath for housing an electrolytic solution. The cathode drum 1 is designed to rotate in a state of being partially (most of the lower half) being dipped in the electrolytic solution.
An insoluble anode (positive electrode) 2 is provided so as to surround the lower half of the outer periphery of the cathode drum 1. A given gap 3 is provided between the cathode drum 1 and the anode 2, and the electrolytic solution is caused to flow therebetween. The device of Fig. 1 is provided with two anode plates.

In Fig. 1, the electrolytic solution is supplied from below, and the electrolytic solution passes through the gap 3 between the cathode drum 1 and the anode 2, overflows from the upper edge of the anode 2, and the electrolytic solution is additionally caused to circulate. A predetermined voltage can be maintained between the cathode drum 1 and the anode 2 via a rectifier.
As the cathode drum 1 rotates, the thickness of the copper that is electrodeposited from the electrolytic solution will increase and, upon reaching a certain thickness, it separates and continuously winds up the raw foil 4. The thickness of the raw foil produced as described above is adjusted based on the distance between the cathode drum 1 and the anode 2, the flow rate of the supplied electrolytic solution, or the supplied electrical charge.
With the copper foil that is produced with this kind of copper foil manufacturing device, the surface that comes in contact with the cathode drum will be a mirrored surface (glossy surface), but the surface on the opposite side will be a rough surface (matted surface) with irregularities. The thickness of this electrolytic copper foil can be selected arbitrarily. Normally, a copper foil having a thickness of 5 µm to 35 µm can be used.

The copper foil produced as described above is subsequently subject to the washing process of removing the oxide film on the surface, and additionally subject to the cleaning process using water. In the washing process, a sulfuric acid aqueous solution of 10 to 80 g/L is normal used.
Although the production of an electrolytic copper foil was described above, in the case of a rolled copper foil, an ingot obtained by melting and casting can be subject to annealing, hot rolling, and additionally cold rolling in order to produce a copper foil of the required thickness. Since a rolled copper foil has a glossy surface on either side, roughening treatment is performed as needed. As this roughening treatment, a well-known roughening treatment can be used.

An example of the roughening treatment is shown below. Moreover, this roughening treatment can also be applied to the glossy surface and matted surface (rough surface) of the electrolytic copper foil. After performing roughening plating, coat plating can also be additionally performed.

### (Roughening plating conditions)

Cu ion concentration: 10 to 30 g/L
Sulfuric acid concentration: 20 to 100 g/L
Electrolytic solution temperature: 20 to 60°C
Current density: 5 to 80 A/dm²
Treatment time: 0.5 to 30 seconds

### (Coat plating conditions)

Cu ion concentration: 30 to 50 g/L
Sulfuric acid concentration: 20 to 100 g/L
Electrolytic solution temperature: 20 to 60°C
Current density: 5 to 80 A/dm²
Treatment time: 0.5 to 30 seconds

The surface of the copper foil that was subject to roughening treatment is measured with an optical interferotype optical surface shape measurement device having a resolution of 0.2 µm × 0.2 µm or less. This is because, as described later, with the surface roughness that is obtained by the JIS standard stylus roughness tester or a laser-based optical shape measurement method, it is not possible to obtain the correlativity of the surface roughness and the resistance value.
As this kind of optical interferotype optical surface shape measurement device, a non-contact three-dimensional surface shape roughness measurement system, product number NT1100 (WYKO optical profiler (resolution: 0.2 µm × 0.2 µm or less) manufactured by Veeco) can be used.
The measurement method of this system is Vertical Scan Interferometry (VSI method), and its visual field is 120 µm × 90 µm, and its measurement scan speed is 7.2 µm/sec. The interferometry is the Mirau interferometry (objective lens: 50x, internal lens: 1x).

A layer made of an electric resistance material is formed on the copper foil that was subject to roughening treatment. As an example of this electric resistance layer, an electric resistive element such as NiCr alloy or NiCrAlSi alloy can be used as a representative example. The layer made of such an electric resistance material is demanded from the perspective of circuit board design, and can be selected arbitrarily. Accordingly, there is no need to limit this to a specific material.
The electric resistance material can be formed by sputtering an electric resistance material target made of NiCr alloy, NiCrAlSi alloy or the like. There is no particular limitation in the sputtering conditions, and a publicly-known sputtering device can be used to form an arbitrary electric resistance material.
The electric resistance film having a resistance value of, for example, roughly 25.0 Ω/sq to 50.0 Ω/sq is normally used, but the resistance value may exceed the foregoing range by changing the film thickness.

The correlativity of the surface roughness of the copper foil surface based on the optical roughness tester (resolution: 0.2 µm × 0.2 µm or less) of the WYKO optical profiler, and the resistance value is as shown in Fig. 1.
As evident from Fig. 1, the surface roughness Rz of the copper foil comprising coarse particles is within the range of 6.0 µm to 8.0 µm, the resistance value Rz is 25.0 Ω/sq to 50.0 Ω/sq, and the resistance value R increases as the surface roughness Rz increases. In addition, since high correlation is acknowledged, the variation of the resistance value can achieve ±5% or less by controlling the surface roughness.

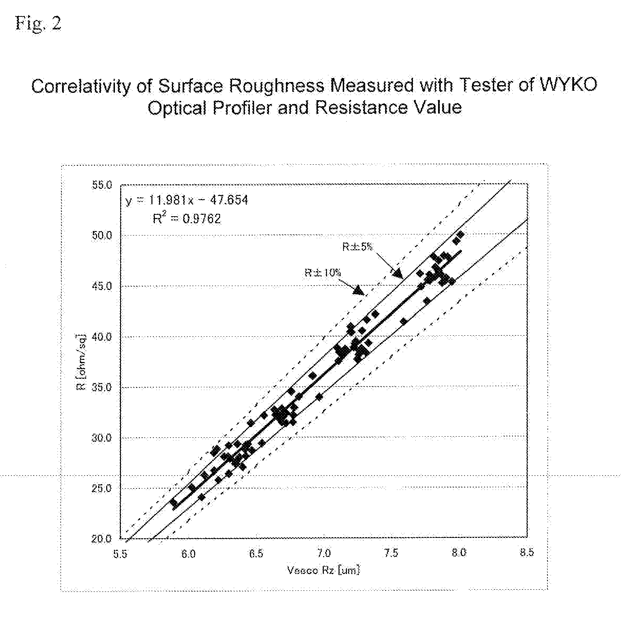

Meanwhile, by way of reference, the correlativity of the surface roughness obtained with the JIS standard stylus roughness tester, and the resistance value is as shown in Fig. 2.
The stylus roughness measurement device used in the foregoing case was Surfcorder Model SE-3C (manufactured by Kosaka Laboratory Ltd.). Note that the measurement using this stylus roughness measurement device was conducted under the following conditions: Stylus: 2 µmR, Load: 0.07 g, Speed: 0.1 mm/min, Measurement Length: 0.8 mm, Measurement Direction: Transverse (direction of 90° relative to the direction of the produced foil).

As shown in Fig. 2, there is no correlation between the surface roughness and the resistance value. The reason for this is considered to be as follows. Specifically, the value that was measured as the surface roughness Rz was 2.4 to 3.0 µm, and is approximately half the value that is obtained by measuring the same sample with the optical interferometry method, and this is because the stylus is of a µm level, and the entry of the stylus into the concave part is physically restricted. Consequently, a measurement value that envelopes the shape of only the upper half of the coarse particles can be obtained.
In other words, with this stylus roughness measurement device, it is not possible to measure the accurate surface roughness Rz.
Moreover, the correlation of the surface roughness and the resistance value is low even with the concavo-convex shape measurement method using a laser (pinhole confocal laser method or the like). Since the obtained surface roughness is greater than the stylus method and smaller than the optical interferometry method, it is considered that, if particles on branches exist on the surface due to the roughening treatment, it is not possible to detect the irregularities hidden in the branches.

With the copper foil with an electric resistance film of the present invention, an optical interferometer having a resolution of 0.2 µm × 0.2 µm is used to measure the surface shape of the copper foil surface that was subject to roughening treatment, and thereby measure the variation of the 10-point average roughness Rz that is calculated from the foregoing shape data, and a copper foil in which the variation of the 10-point average roughness Rz is 5% or less, and additionally 3% or less is used. In addition, an electric resistance film is formed on the roughened surface of the copper foil, and the variation of the electric resistance is inhibited.
It is thereby possible to achieve a variation of resistivity of the electric resistance film of 10% or less, and even 5% or less in the width direction of the copper foil, and thus provide a copper foil with an electric resistance film comprising the foregoing characteristics.

Moreover, the surface shape of the copper foil can also be measured before forming the electric resistance film using the optical roughness tester of the WYKO optical profiler or an equivalent device having a resolution of 0.2 µm × 0.2 µm or less.
In the present invention, a copper foil having a foil thickness of 5 to 70 µm, in particular a copper foil of 5 to 35 µm can be used. Moreover, as the copper foil on which the electric resistance layer was formed in the present invention, either an electrolytic copper foil or a rolled copper foil that was subject to roughening treatment can be used.

### [Examples]

The Examples of the present invention are now explained. Incidentally, these Examples are provided for facilitating the understanding of the present invention, and the present invention shall in no way be limited thereby. In other words, various modifications and other embodiments based on the technical spirit claimed in the claims shall be covered by the present invention as a matter of course.

### (Example 1)

In Example 1, an electrolytic copper foil having a thickness of 18 µm was used. Roughening treatment was performed to the rough surface (matted surface) side of the electrolytic copper foil The roughening treatment was performed for 3 seconds at a current density of 42 A/dm² under the foregoing roughening plating conditions.
The fluctuation of the surface roughness caused by the temperature, carrier speed, electrolytic solution and other statuses was controlled by adjusting the treatment time, and a roughened electrolytic copper foil having a 10-point average roughness Rz of 6.3 µm and a variation of ±5% was prepared. The results are shown in Table 1.

**[Table 1]**

| | Current Density (A/dm²) | Rz (µm) | Variation of Rz(%) | Normal Peel Value(kN/m) | Heat Resistance Peel Value(kN/m) |
|---|---|---|---|---|---|
| Example 1 | 42 | 6.3 | 5 | 0.67 | 0.65 |
| Example 2 | 49 | 6.7 | 4 | 0.84 | 0.80 |
| Example 3 | 55 | 7.2 | 4 | 1.08 | 0.99 |
| Example 4 | 63 | 7.9 | 4 | 1.17 | 1.09 |
| Comparative Example 1 | - | 5.1 | 3 | 0.29 | 0.27 |

Subsequently, the roughened electrolytic copper foil was used, and an electric resistance material made of alloy or 80% nickel (Ni) and 20% chromium (Cr) was attached to the stabilization layer under the following conditions.
Ni/Cr alloy sputtering: 62-inch width sputtering device
Power: 45 kw
Linear velocity: 3 ft/min (0.9m/min)
Thickness of Ni/Cr alloy: 500 A
When a roughened electrolytic copper foil of Rz 6.3 µm was used, the sheet resistivity of the resistance material was 28 Ω/sq (square), and the variation was 7%. The results are shown in Table 2.

**[Table 2]**

| | Current Density (A/dm²) | Resistivity (Ω/sq) | Variation of Resistivity (%) |
|---|---|---|---|
| Example 1 | 42 | 28 | 7 |
| Example 2 | 49 | 32 | 6 |
| Example 3 | 55 | 38 | 5 |
| Example 4 | 63 | 46 | 5 |
| Comparative Example 1 | - | 27-48 | 50 |

As a result of bonding the copper foil with an electric resistance film prepared as described above to a polyimide resin substrate, the normal peel value was 0.67 kN/m, and the peel value after the solder treatment (heat resistance peel value) was 0.65 kN/m. The results are shown in Table 1.
Note that the peel value after the solder treatment was obtained by measuring the peel value after dipping the foregoing polyimide resin substrate to which the copper foil with an electric resistance film was bonded in a molten solder bath of 260°C for 20 seconds (that is, in a state of being subject to heating treatment); that is, the peel value after the solder treatment shows the peel value after the foregoing treatment (after being affected by heat). This is used for evaluating the heat resistance performance.

### (Example 2)

In Example 2, an electrolytic copper foil having a thickness of 18 µm was used. Roughening treatment was performed to the rough surface (matted surface) side of the electrolytic copper foil. The roughening treatment was performed for 3 seconds at a current density of 49 A/dm² under the foregoing roughening plating conditions.

The fluctuation of the surface roughness caused by the temperature, carrier speed, electrolytic solution and other statuses was controlled by adjusting the treatment time, and a roughened electrolytic copper foil having a 10-point average roughness Rz of 6.7 µm and a variation of ±4% was prepared. The results are similarly shown in Table 1.

Subsequently, the same electric resistance material as Example 1 was attached to the stabilization layer under the same conditions. Consequently, in the case of Example 2 that used a roughened electrolytic copper foil of Rz 6.7 µm, the sheet resistivity of the resistance material was 32 Ω/sq (square), and the variation was 6%. The results are shown in Table 2.
As a result of bonding the copper foil with an electric resistance film prepared as described above to a polyimide resin substrate, the normal peel value was 0.84 kN/m, and the peel value after the solder treatment (heat resistance peel value) was 0.80 kN/m. The results are shown in Table 1. Note that the peel value after the solder treatment was evaluated under the same conditions as Example 1.

### (Example 3)

In Example 3, an electrolytic copper foil having a thickness of 18 µm was used. Roughening treatment was performed to the rough surface (matted surface) side of the electrolytic copper foil. The roughening treatment was performed for 3 seconds at a current density of 55 A/dm² under the foregoing roughening plating conditions.

The fluctuation of the surface roughness caused by the temperature, carrier speed, electrolytic solution and other statuses was controlled by adjusting the treatment time, and a roughened electrolytic copper foil having a 10-point average roughness Rz of 7.2 µm and a variation of ±4% was prepared. The results are similarly shown in Table 1.

Subsequently, the same electric resistance material as Example 1 was attached to the stabilization layer under the same conditions. Consequently, in the case of Example 2 that used a roughened electrolytic copper foil of Rz 7.2 µm, the sheet resistivity of the resistance material was 38 Ω/sq (square), and the variation was 5%. The results are shown in Table 2.
As a result of bonding the copper foil with an electric resistance film prepared as described above to a polyimide resin substrate, the normal peel value was 1.06 kN/m, and the peel value after the solder treatment (heat resistance peel value) was 0.99 kN/m. The results are shown in Table 1. Note that the peel value after the solder treatment was evaluated under the same conditions as Example 1.

### (Example 4)

In Example 4, an electrolytic copper foil having a thickness of 18 µm was used. Roughening treatment was performed to the rough surface (matted surface) side of the electrolytic copper foil. The roughening treatment was performed for 3 seconds at a current density of 63 A/dm² under the foregoing roughening plating conditions.

The fluctuation of the surface roughness caused by the temperature, carrier speed, electrolytic solution and other statuses was controlled by adjusting the treatment time, and a roughened electrolytic copper foil having a 10-point average roughness Rz of 7.9 µm and a variation of ±4% was prepared. The results are similarly shown in Table 1.

Subsequently, the same electric resistance material as Example 1 was attached to the stabilization layer under the same conditions. Consequently, in the case of Example 2 that used a roughened electrolytic copper foil of Rz 7.9 µm, the sheet resistivity of the resistance materials was 46 Ω/sq (square), and the variation was 5%. The results are shown in Table 2.
As a result of bonding the copper foil with an electric resistance film prepared as described above to a polyimide resin substrate, the normal peel value was 1.17 kN/m, and the peel value after the solder treatment (heat resistance peel value) was 1.09 kN/m. The results are shown in Table 1. Note that the peel value after the solder treatment was evaluated under the same conditions as Example 1.

### (Comparative Example 1)

Using the same conventional stylus roughness tester as Example 1, upon forming an electric resistance layer of 2.7 µm on an electrolytic copper foil of 18 µm and bonding it to a polyimide resin substrate, the normal peel value was 0.29 kN/m, and the peel value after the solder treatment (heat resistance peel value) was 0.27 kN/m, and the results were extremely inferior in comparison to Examples 1 to 4.
With Comparative Example 1, as a result of measuring the surface roughness with an optical roughness tester, Rz decreased to 5.1 µm as shown in Table 1. Consequently, it is considered that the smallness of the surface roughness led to the decrease in the normal peel value and the peel value after the solder treatment (heat resistance peel value).

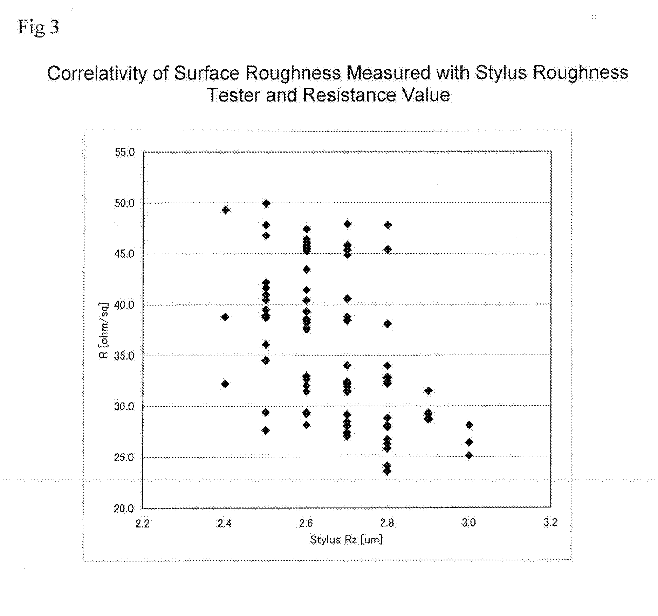

Moreover, the surface roughness of the foils of Examples 1 to 4 was measured using a contact-type roughness tester. The results were, as shown in Fig. 3, that no correlativity could be acknowledged between the contact roughness Rz and the resistance value, and it was difficult to confirm the resistance value based on the surface roughness date.
It was therefore impossible to obtain a correlation between Rz and the resistance value with a conventional stylus roughness tester, and it was discovered that it is not possible to obtain the optimal conditions.

Consequently, all Examples were able to achieve a variation of the resistance value of the electric resistance film of ±10%, or less while achieving a normal peel value of 0.67 kg/cm or more, and a peel value (heat resistance peel value) after solder treatment of 0.65 kg/cm or more, and ensuring superior adhesiveness. All of the Examples coincide with the conditions of the present invention, and possessed favorable characteristics.

### INDUSTRIAL APPLICABILITY

The present invention yields superior effects of being able to obtain a copper foil comprising an electric resistance film possessing favorable adhesiveness and capable of inhibiting the fluctuation or variation of the resistance value, which are drawbacks associated with a copper foil with an electric resistance film built therein.
As a result of using the copper foil of the present invention having an electric resistance film built therein, there is no need to independently form a new electric resistive element upon the circuit design, and it is only necessary to expose the resistive element by subjecting the electric resistance film formed on the copper foil to an etching solution such as cupric chloride. Thus, an effect is yielded in that solder bonding becomes unneeded or is considerably reduced, and that the mounting process can be considerably simplified.
Moreover, as a result of the number of mounted components and soldering processes being reduced, there is also an advantage in that the space can be expanded and downsizing and weight-saving can be achieved. It is thereby possibly to improve the freedom of the circuit design. Moreover, as a result of the resistive element being built into the copper foil as described above, the present invention is effective as a printed circuit board since it comprises the effect of improving the signal properties in a high frequency range.

## Claims

1. A metal foil with an electric resistance film in which the metal foil is made of copper or copper alloy, the surface roughness of at least one surface thereof is set to a 10-pint average roughness Rz of 6.0 µm to 8.0 µm, and an electric resistance film is formed on that surface, wherein the peel strength of the electric resistance film is 0.60 kN/m or more, and variation of the resistance value is ±5% or less.

2. The metal foil with an electric resistance film according to claim 1, wherein the electric resistance layer is provided to the surface of an electrolytic copper foil or a rolled copper foil that was subject to roughening treatment.

3. The metal foil with an electric resistance film according to claim 1 or claim 2, wherein the variation of the resistance value of the electric resistance film is ±3% or less.

4. The metal foil with an electric resistance film according to any one of claims 1 to 3, wherein the foil thickness of the metal foil is 5 to 35 µm.

5. A method of producing a metal foil with an electric resistance film, wherein the surface of a copper or copper alloy metal foil made of an electrolytic copper foil or a rolled copper foil is subject to roughening treatment via electrolysis so that the surface roughness becomes a 10-point average roughness of Rz 6.0 µm to 8.0 µm, and an electric resistance film is formed on the roughened surface via a physical surface treatment method such as a sputtering method, a vacuum deposition method, or an ion beam plating method, a chemical surface treatment method such as a pyrolysis method or a gas-phase reaction method, or a wet surface treatment method such an electroplating method or an electroless plating method, whereby the peel strength of the electric resistance film is 0.60 kN/m or more, and variation of the resistance value of the electric resistance film is ±10% or less.

6. The method of producing a metal foil with an electric resistance film according to claim 5, wherein the variation of the resistance value of the electric resistance film is +5% or less.

7. The method of producing a metal foil with an electric resistance film according to claim 5 or claim 6, wherein coat plating is additionally performed after the roughening treatment via electrolysis.
